# EUROPEAN PATENT APPLICATION

(11) **EP 2 040 125 A1**
(43) Date of publication of application: **25.03.2009**
(21) Application number: 07790411.8
(22) Date of filing: 22.06.2007
(51) Int. Cl.: G03F 7/40, G02B 5/20, H01L 21/027

(54) **METHOD OF FORMING MICROFINED RESIST PATTERN**

(30) Priority: 22.06.2006 JP 2006172888
(71) Applicant: AZ Electronic Materials USA Corp., Somerville, NJ 08876 (US)
(72) Inventor: NOYA, Go, Kakegawa-shi, Shizuoka 437-1412 (JP); KOBAYASHI, Masakazu, Kakegawa-shi, Shizuoka 437-1412 (JP); SHIMAZAKI, Ryuta, Haibara-gun, Shizuoka 4210304 (JP)
(74) Representative: Rippel, Hans Christoph
(86) International application number: PCT/JP2007/062565
(87) International publication number: WO 2007/148776

(57) **Abstract**

The present invention provides a pattern-producing method for fining a developed resist pattern without increasing the production cost or impairing the production efficiency seriously. This method comprises the step of bringing a resist pattern after development into contact with a treating solution preferably containing a nonionic surfactant for 60 seconds or more, so as to reduce the effective size of the resist pattern formed by the development. The present invention also provides a resist pattern fined by that method.

## Description

### TECHNICAL FIELD

The present invention relates to a method for producing a resist pattern. In detail, this invention relates to a method in which a fined pattern is produced by applying a chemical treating solution to a resist pattern employed for manufacture of color filters, semiconductor devices, and flat panel displays (FPDs) such as liquid crystal display elements.

### Background Art

In extensive fields including the manufacture of semiconductor integrated circuits such as LSIs, the preparation of FPD screens, and the production of circuit boards for color filters, thermal heads and the like, photolithography has hitherto been used for formation of fine elements or microfabrication. In the photolithography, a positive- or negative-working photosensitive resin composition is used for resist pattern formation. As the positive-working photoresist, a photosensitive resin composition comprising an alkali-soluble resin and a photosensitive substance of quinonediazide compound, for example, is widely used.

Meanwhile, in recent years in manufacturing fine electronic devices, increased integration density and highly accelerated processing speed in LSIs have led to design rules requiring quarter-micron- or finer-scale fabrication rather than half-micron-scale fabrication, which the design rules formerly required. Since conventional light for exposure such as visible light or near UV light (wavelength: 400 to 300 nm) cannot fully cope with the design rules requiring finer fabrication, it is necessary to use radiation of shorter wavelength such as far UV light emitted from a KrF excimer laser (248 nm), an ArF excimer laser (193 nm) or the like, an X-ray or an electron beam. Accordingly, lithographic processes using the radiation of shorter wavelength have been proposed and gradually getting used in practice. To cope with the design rules requiring finer fabrication, the photoresist used in microfabrication must be a photosensitive resin composition capable of giving a pattern of high resolution. Further, it is also desired that the photosensitive resin composition be improved not only in resolution but also in sensitivity and in accuracy on shape and dimension of the pattern. In view of this, as a radiation-sensitive resin composition having sensitivity to the radiation of short wavelength and giving a pattern of high resolution, a "chemically amplified photosensitive resin composition" has been proposed. The chemically amplified photosensitive resin composition comprises a compound that generates an acid when exposed to radiation, and hence when the radiation is applied, the compound generates an acid and the acid serves as a catalyst in image-formation to improve sensitivity. Since the chemically amplified photosensitive resin composition is thus advantageous, it has been getting popularly used in place of conventional photosensitive resin compositions.

However, although photosensitive resin compositions have been thus studied and developed to increase the fineness in fabrication, finer fabrication is still required of design rules. Accordingly, it is studied from a new viewpoint to fine resist patterns further.

For example, Patent document 1 describes a method in which a pattern obtained by a usual process is further covered with a uniform coating layer to narrow the width of the trench pattern or to reduce the diameter of the contact hole. This method makes it possible to further fine the patterns having been already fined to the utmost limit by the photolithographic pattern-formation method using the photosensitive resin composition.

However, in the method disclosed in Patent document 1, a coating composition is spread on a pattern prepared beforehand, and then heated or exposed to light to harden, so that the pattern is thickened. Accordingly, it is necessary to perform an additional step in a process of that method. Therefore, in view of production cost and efficiency, there is room for improvement.
[Patent document 1] Japanese Patent Laid-Open No. H10(1998)-73927

### DISCLOSURE OF INVENTION

### PROBLEM TO BE SOLVED BY THE INVENTION

In consideration of the aforementioned problem, the present invention has an object to provide a method for fining a pattern without increasing the production cost or impairing the production efficiency seriously.

### MEANS FOR SOLVING PROBLEM

The present invention resides in a pattern forming method for producing a fined resist pattern, comprising the step of: bringing a resist pattern after development into contact with a treating solution comprising a nonionic surfactant for 60 seconds or more, so as to reduce the effective size of said resist pattern formed by the development.

The present invention also resides in a fined resist pattern, produced by the steps of: developing an imagewise-exposed resist substrate with a developer, and then bringing the developed resist into contact with a treating solution containing a nonionic surfactant for 60 seconds or more.

### EFFECT OF THE INVENTION

According to the present invention, a pattern can be fined without increasing the production cost or impairing the production efficiency seriously. In a production process according to the present invention, it is unnecessary to introduce a new apparatus and relatively inexpensive materials are used, and hence a fined pattern can be produced without increasing the production cost.

### BEST MODE FOR CARRYING OUT THE INVENTION

The method for producing a fined pattern according to the present invention is described below in detail.
In the pattern-production method of the invention, a resist pattern after development is brought into contact with a treating solution. There is no particular restriction on the process by which a resist pattern is developed to obtain the pattern to be treated, and hence any process can be adopted. Accordingly, the lithographic process for preparing the pattern to be treated can be carried out in any known manner of forming a resist pattern from a conventional positive- or negative-working photosensitive resin composition. A typical process for forming a pattern to be treated with the treating solution of the invention is described below.

First, a photosensitive resin composition is spread on a surface (which can be pretreated, if necessary) of a substrate (such as a silicon substrate or a glass substrate) according to a known coating method (such as spin-coating method), to form a photosensitive resin composition layer. Prior to the coating of the photosensitive resin composition, an antireflection film can be beforehand formed by coating under or above the resist. The antireflection film can improve the section shape and the exposure margin.

Any photosensitive resin composition can be used in the pattern-producing method of the present invention. Representative examples of the compositions usable in the invention include: a composition comprising a photosensitive substance of quinonediazide type and an alkali-soluble resin, a chemically amplified photosensitive resin composition (which are positive-working compositions); a composition comprising a photosensitive functional group-containing polymer such as polyvinyl cinnamate, a composition comprising an azide compound such as an aromatic azide compound or a bisazide compound with a cyclized rubber, a composition comprising a diazo resin, a photo-polymerizable composition comprising an addition-polymerizable unsaturated compound, and a chemically amplified negative-working photosensitive resin composition (which are negative-working compositions)

Examples of the photosensitive substance of quinonediazide type used in the positive-working composition comprising a photosensitive substance of quinonediazide type and an alkali-soluble resin include: 1,2-benzoquinonediazide-4-sufonic acid, 1,2-naphthoquinonediazide-4-sufonic acid, 1,2-naphthoquinonediazide-5-sufonic acid, and sufonic esters or amides thereof. Examples of the alkali-soluble resin include: novolak resin, polyvinyl phenol, polyvinyl alcohol, and copolymers of acrylic acid or methacrylic acid. The novolak resin is preferably prepared from one or more of phenols such as phenol, o-cresol, m-cresol, p-cresol and xylenol in combination with one or more of aldehydes such as formaldehyde and paraformaldehyde

Either positive- or negative-working chemically amplified photosensitive resin composition can be used in the pattern-production method of the invention. The chemically amplified resist generates an acid when exposed to radiation, and the acid serves as a catalyst to promote chemical reaction by which solubility to a developer is changed within the areas irradiated with the radiation to form a pattern. For example, the chemically amplified photosensitive resin composition comprises an acid-generating compound, which generates an acid when exposed to radiation, and an acid-sensitive functional group-containing resin, which decomposes in the presence of acid to form an alkali-soluble group such as phenolic hydroxyl or carboxyl group. The composition may comprise an alkali-soluble resin, a crosslinking agent and an acid-generating compound.

The photosensitive resin composition layer formed on the substrate is prebaked, for example, on a hot plate to remove solvent contained in the composition, and thereby a photoresist film having a thickness of normally 0.5 to 2.5 microns is prepared. The prebaking temperature depends upon the solvent and the photosensitive resin composition, but is normally 20 to 200°C, preferably 50 to 150°C. The photoresist film is then subjected to exposure through a mask, if necessary, by means of known exposure apparatus such as a high-pressure mercury lamp, a metal halide lamp, an ultra-high pressure mercury lamp, a KrF excimer laser, an ArF excimer laser, a soft X-ray irradiation system, and an electron beam lithography system.

After the exposure, baking treatment may be carried out, if necessary, and then development such as paddle development is carried out to form a resist pattern. The resist is normally developed with an alkali developer. Examples of the alkali developer include an aqueous solution or a waterborne solution of sodium hydroxide or tetramethylammonium hydroxide (TMAH). After the development, the resist pattern is rinsed (washed) with a rinse solution, preferably, pure water. The thus-formed resist pattern is employed as a resist for etching, plating, ion diffusion or dyeing, and then, if necessary, peeled away.

The pattern-production method according to the present invention particularly enables a fine resist pattern to be further fined. Accordingly, the method of the invention is preferably combined with a lithographic process capable of giving a fine resist pattern, such as, a lithographic process comprising exposure at a wavelength of 250 nm or shorter with a KrF excimer laser, an ArF excimer laser, a X-ray irradiation system, or an electron beam lithography system as a light source. Further, the lithographic process preferably produces a resist pattern having a pattern dimension in which a line width of the line-and-space pattern or a hole diameter of the contact hole pattern is not larger than 300 nm, preferably not larger than 200 nm.

The thickness of the resist pattern is properly determined according to the use, and is generally in the range of 0.1 to 2.5 µm, preferably 0.2 to 1.5 µm.

In the pattern-production method of the present invention, the resist pattern after development is treated with a treating solution containing a nonionic surfactant. Here, the term "nonionic surfactant" means a nonionic compound giving a surface tension of 50 mN/m or less, preferably 45 mN/N or less, at 20°C, when dissolved in water in a concentration of 0.5 wt.%. Examples of the nonionic surfactant usable in the invention include: polyether surfactants, which are addition-polymers of hydroxyl-containing compounds (such as higher alcohols and alkyl phenols) with alkylene oxides; ester surfactants, which have structures in which polyhydric alcohols and higher fatty acids are combined with ester bonds; fatty acid alkanol amides; alkylpolyglycoside; and sorbitan-fatty acid esters. Preferred is a polyether surfactant having plural polyether bonds. The molecular weight of the surfactant can be properly selected according to necessity, and is generally in the range of 300 to 50000, preferably 500 to 30000, more preferably 500 to 10000. However, since the proper molecular weight depends upon the main chain structure and the functional groups contained therein, surfactants having molecular weights out of the above range are also usable. Nonionic surfactants are generally known well, and various commercially available surfactants are employable. Examples of them include: products-of TAKEMOTO OIL & FAT Co., Ltd., Pionine D-225 [trade mark] (as in the subsequent description) (polyoxyethylene-caster oil ether), Pionine D-2506D (polyethylene glycol dioleyl ester), Pionine D-3110 (polyoxyethylene alkylaminoether), Pionine P-1525 (polyethylene glycol-polypropylene glycol block copolymer), Pionine P-2820 (polyalkylene ether), Pionine B-6112-W (polyoxyalkylene polystyrylphenyl ether-ethylene oxide/propylene oxide adduct (60/40)), Pionine K-17 (polyoxyalkylene diglyceryl ether-ethylene oxide/propylene oxide adduct (10/90)), Pionine D-2507A (polyoxyethylene oleate), Pionine D-1007 (polyoxyethylene octyl ether), Pionine P-1050-B (polyoxyalkylene butyl ether-ethylene oxide/propione oxide adduct (50/50)), and Pionine D-3240 (polyoxyethylene alkylaminoether); products of Gelest, Inc. (UK), DBP-534 (dimethylsiloxane-(adduct of ethylene oxide/propione oxide (40/60)) block copolymer); products of Air Products & Chemical, Inc. (Pennsylvania, US), Surfynol 420 (acetylene glycol-polyethylene oxide (1 mole) adduct), Surynol 440 (acetylene glycol-polyethylene oxide (3.5 mole) adduct), and Surfynol 2502 (acetylene glycol-ethylene oxide (5 mole)/propylene oxide (2 mole) adduct); and triisopropanolamine-ethylene oxide/propyrene oxide adduct (40/60).

There is no particular restriction on the concentration of the nonionic surfactant contained in the treating solution, but it is preferred to control the concentration according to what to use the pattern for and how to use the pattern. Generally, the treating solution containing the surfactant in a high concentration is apt to shorten the time to complete the treatment, and has large effect on reducing the effective size of the resist pattern. On the other hand, if the treating solution contains the surfactant in a low concentration, it takes a short time to complete rinsing with pure water after the treatment. Further, it depends upon the photosensitive resin composition and other conditions what surfactant is suitable and how much the surfactant is preferably used. Accordingly, the concentration is preferably determined according to the required characteristics. The preferred concentration of the nonionic surfactant is thus not determined, but is generally in the range of 0.01 to 5%, preferably 0.05 to 2%, more preferably 0.1 to 1%. Further, the time for which the resist substrate is kept in contact with the treating solution, namely, the treating time, is not particularly limited as long as it is not shorter than 60 seconds, but preferably is not shorter than 120 seconds, more preferably not shorter than 300 seconds, so as to obtain large effect on reducing the effective size of the resist pattern. The upper limit of the treating time is not particularly limited, but the treating time is preferably not longer than 60 minutes in view of the production efficiency. It has been conventionally known that the resist pattern after development is rinsed with a rinse solution containing a surfactant, but the time for that conventional rinsing is much shorter than 60 seconds. Further, it has been hitherto unknown that the pattern size is changed when treated with a rinse solution containing a particular surfactant.

There is also no particular restriction on the temperature of the treating solution. However, in view of the effect on reducing the effective size of the resist pattern and of uniformity in the reduced size, the temperature is generally in the range of 10 to 50°C, preferably 20 to 30°C.

The treating solution according to the present invention comprises the aforementioned nonionic surfactant and a solvent.
As the solvent, water is usually used. However, for improving wettability, a small amount of organic solvent can be added as a cosolvent. Examples of the cosolvent include alcohols such as methanol and ethanol, ketones such as acetone and methyl ethyl ketone, and esters such as ethyl acetate. If necessary, other auxiliary components can be incorporated. For example, acidic or basic substances and surfactants other than the nonionic surfactant can be added unless they impair the effect of the present invention.

In the pattern-production method according to the present invention, the resist substrate after development is preferably rinsed with pure water before and/or after brought into contact with the treating solution. The rinse step before the step of treatment with the treating solution is carried out for the purpose of washing out a developer remaining on the resist pattern. In order to prevent the developer from contaminating the treating solution and to obtain the effect of the invention with a minimum amount of the treating solution, the resist substrate after development is preferably rinsed with pure water before brought into contact with the treating solution. On the other hand, the rinse step after the step of treatment with the treating solution is for washing out said treating solution. Particularly in the case where the treating solution has a high concentration, the rinsing with pure water is preferably carried out after the treatment with the treating solution so that the resist pattern may not undergo troubles in the subsequent steps, for example, so that the treating solution remaining on the resist surface may not cause problems in the etching step.

The rinsing with pure water can be carried out in a desired manner. For example, the resist substrate is immersed in the rinse solution, or otherwise the rinse solution is dropped or sprayed onto the substrate surface while the substrate is being rotating. The rinsing with pure water can be performed either before or after, or otherwise both before and after the treatment with the treating solution.

In the present invention, the resist pattern after development is brought into contact with the aforementioned treating solution. After the development or after the rinsing with pure water, the resist pattern is normally not dried and immediately brought into contact with the treating solution. However, if necessary, before brought into contact with the treating solution, the resist pattern can be dried immediately after the development or after the rinsing subsequent to the development. Even so, the effect of the invention can be obtained.

The resist pattern having an effective size thus reduced by the pattern-production method of the invention is then further processed according to the use of the pattern. The pattern-production method of the invention by no means restricts the subsequent steps, and hence the resist pattern can be processed in known manners.

The following Examples further illustrate the present invention, but are not intended to limit it.

### Comparative Example 1 and Examples 1 and 2

A silicon substrate was spin-coated with a resist composition DX 6270P ([trade mark], positive-working photoresist manufactured by AZ Electronic Materials K. K.), and heated at 125°C for 90 seconds to obtain a 0.5 µm-thick photoresist film. On the photoresist film, a 1:1 trench pattern having a width of 300 nm was exposed using a stepper FPA-3000EX5 ([trade mark], manufactured by Canon Inc.). Thereafter, post-exposure baking (PEB) was carried out at 130°C for 90 seconds, and then paddle development was carried out with 2.38% aqueous solution of tetramethylammonium hydroxide for 60 seconds. Successively, after rinsed with pure water for 15 seconds, the obtained pattern was immersed in the treating solution for various periods. The treated pattern was again rinsed with pure water for 15 seconds, spin-dried for 30 seconds, and then naturally dried.

The treating solution was a 0.1 wt.% aqueous solution of each surfactant shown in Table 1, and the time for immersing in the treating solution was 15, 30, 60, 120, 300 or 600 seconds.
For evaluating the pattern, the width of the pattern brought into contact with the treating solution and that of the pattern not brought into were measured by means of a highly-precise apparent dimension measuring system S-9200 ([trade mark], manufactured by Hitachi, Ltd.), to obtain the difference (in terms of Å) between the former and the latter. The results were as set forth in Table 1.

**[Table 1]**

| | Surfactant | | Treating Time (sec) | | | | | |
|---|---|---|---|---|---|---|---|---|
| | kind | Compound | 15 | 30 | 60 | 120 | 300 | 600 |
| Example 1 | nonionic | polyoxyalkylene -polystyrylphenyl ether^{*1} | 10 | 13 | 61 | 270 | 484 | 647 |
| Example 2 | nonionic | polyoxyalkylene diglyceryl ether^{*2} | 20 | 24 | 97 | 252 | 382 | 493 |
| Example 3 | nonionic | dimethylsiloxane-(60% propylene oxide-40% ethylene oxide) block copolymer^{*3} | 12 | 34 | 160 | 299 | 364 | 458 |
| Example 4 | nonionic | polyalkylene ether^{*4} | 11 | 24 | 54 | 127 | 164 | 247 |
| Example 5 | nonionic | polyoxyethylene oleate^{*5} | 20 | 25 | 76 | 154 | 176 | 233 |
| Example 6 | nonionic | acetyleneglycol-ethylene oxide/propyrene oxide adduct^{*6} | 11 | 12 | 77 | 126 | 142 | 160 |
| Example 7 | nonionic | polyoxyethylene octyl ether^{*7} | 15 | 34 | 61 | 119 | 118 | 143 |
| Example 8 | nonionic | polyoxyalkylene butyl ether^{*8} | 9 | 28 | 61 | 65 | 77 | 92 |
| Example 9 | nonionic | triisopropanolamine-ethylene oxide/propyrene oxide adduct^{*9} | 8 | 16 | 51 | 73 | 81 | 92 |
| Example 10 | nonionic | perfluorooctyl surufonic acid polyether ester^{*10} | 7 | 26 | 59 | 66 | 71 | 88 |
| Example 11 | nonionic | polyoxyethylene stearylaminoether^{*11} | 8 | 16 | 55 | 59 | 66 | 78 |
| Comp. Ex. 1 | cationic | didecyl dimethyl ammonium chloride | 2 | 2 | 2 | 1 | 0 | 12 |
| Comp. Ex. 2 | anionic | perfluorooctyl surfonic acid | -2 | -4 | -4 | -3 | 0 | 8 |
| Comp. Ex. 3 | cationic | Cetylpyridinium chloride | 2 | 2 | 4 | 2 | 0 | 8 |
| Comp. Ex. 4 | anionic | telomer surufonic acid (carbon number: 6)^{*12} | -3 | -1 | -3 | -1 | 0 | 5 |
| Comp. Ex. 5 | anionic | alkyl surfonic acid (carbon number: 14-16)^{*13} | 2 | 2 | 2 | 1 | 0 | 2 |

### Details of surfactants

*1) polyoxyalkylene polystyrylphenyl ether-ethylene oxide/propylene oxide adduct (60/40) (molecular weight: 1200) (Pionine B-6112-W [trade mark], manufactured by TAKEMOTO OIL & FAT Co., Ltd.),
*2) polyoxyalkylene diglyceryl ether-ethylene oxide/propylene oxide adduct (10/90) (molecular weight: 2500) (Pionine K-17 [trade mark], manufactured by TAKEMOTO OIL & FAT Co., Ltd.),
*3) dimethylsiloxane-(adduct of ethylene oxide/propione oxide (40/60)) block copolymer (molecular weight: 30000) (DBP-534 [trade mark], manufactured by Gelest, Inc. (UK))
*4) polyalkylene ether (Pionine P-2820 [trade mark], manufactured by TAKEMOTO OIL & FAT Co., Ltd.),
*5) polyoxyethylene oleate (molecular weight: 600) (Pionine D-2507A [trade mark], manufactured by TAKEMOTO OIL & FAT Co., Ltd.),
*6) Surfynol 2502 ([trade mark], manufactured by Air Products & Chemical, Inc.),
*7) polyoxyethylene octyl ether (molecular weight: 440) (Pionine D-1007 [trade mark], manufactured by TAKEMOTO OIL & FAT Co., Ltd.),
*8) polyoxyalkylene butyl ether-ethylene oxide/propione oxide adduct (50/50) (molecular weight: 1200) (Pionine P-1050-B [trade mark], manufactured by TAKEMOTO OIL & FAT Co., Ltd.),
*9) triisopropanolamine-ethylene oxide/propyrene oxide adduct (40/60) (molecular weight: approx. 2500),
*10) perfluoroalkyl ethylene oxide adduct (MEGAFACE F-443 [trade name], manufactured by Dai-nippon Ink & Chemicals, Inc.),
*11) D-3240 ([trade mark], manufactured by TAKEMOTO OIL & FAT Co., Ltd.),
*12) MEGAFACE TF-2033 ([trade name], manufactured by Dai-nippon Ink & Chemicals, Inc.),
*13) alkylsulfonic acid (molecular weight: 330) (Pionine A-32-FW [trade mark], manufactured by TAKEMOTO OIL & FAT Co., Ltd.).

## Claims

1. A pattern forming method for producing a fined resist pattern, comprising the step of: bringing a resist pattern after development into contact with a treating solution comprising a nonionic surfactant for 60 seconds or more, so as to reduce the effective size of said resist pattern formed by the development.

2. The pattern forming method according to claim 1, wherein the nonionic surfactant is a surfactant of polyether type.

3. The pattern forming method according to claim 1 or 2, wherein a rinse step of washing with pure water is further performed immediately before and/or after the step of treatment with the treating solution.

4. The pattern forming method according to any one of claims 1 to 3, wherein the resist pattern has a pattern dimension in which a line width of the line-and-space pattern or a hole diameter of the contact hole pattern is not larger than 300 nm.

5. The pattern forming method according to any one of claims 1 to 4, wherein the temperature of the treating solution is in the range of 5 to 50°C.

6. A fined resist pattern, produced by the steps of: developing an imagewise-exposed resist substrate with a developer, and then bringing the developed resist into contact with a treating solution containing a nonionic surfactant for 60 seconds or more.
